# EUROPÄISCHE PATENTSCHRIFT

(11) **EP 3 002 262 B1**
(45) Veröffentlichungstag und Bekanntmachung des Hinweises auf die Patenterteilung: **27.06.2018**
(21) Anmeldenummer: 14187320.8
(22) Anmeldetag: 01.10.2014
(51) Int. Cl.: C03B 19/14, C23C 16/44, C03B 20/00

(54) **Verfahren zur Herstellung von synthetischem Quarzglas mittels einer polymerisierbaren Polyalkylsiloxanverbindung**
Method for the manufacture of synthetic quartz glass with polymerizable polyalkylsiloxane
Procédé de fabrication de verre de quartz synthétique au moyen d'un polyalkylsiloxane polymérisable

(43) Veröffentlichungstag der Anmeldung: 06.04.2016
(73) Patentinhaber: Heraeus Quarzglas GmbH & Co. KG, 63450 Hanau (DE)
(72) Erfinder: Sayce, Ian George, Stocksfield, Northumberland NE 43 7NX (GB); Trommer, Martin, 06749 Bitterfeld (DE)
(74) Vertreter: Gille Hrabal

(56) Entgegenhaltungen:
- DE-A1-102011 121 356
- GB-A- 2 459 943
- US-A- 5 276 173
- US-A1- 2004 039 219

## Beschreibung

Die vorliegende Erfindung betrifft ein Verfahren zur Herstellung von synthetischem Quarzglas. Darüber hinaus betrifft die vorliegende Erfindung die Verwendung einer Polyalkylsiloxanverbindung, welche bestimmte Spezifikationen an Chlorgehalt, Gehalt an metallischen Verunreinigungen aufweist zur Herstellung von synthetischem Quarzglas.Zur Herstellung von synthetischem Quarzglas werden aus einer siliziumhaltigen Ausgangssubstanz in einem CVD-Verfahren durch Hydrolyse oder Oxidation SiO₂-Partikel erzeugt und auf einem sich bewegenden Träger abgeschieden. Es kann dabei zwischen Außen- und Innenabscheideverfahren unterschieden werden. Bei Außenabscheideverfahren werden die SiO₂-Partikel auf der Außenseite eines rotierenden Trägers aufgebracht. Als Beispiele für entsprechende Außenabscheideverfahren seien das so genannte OVD-Verfahren (Outside Vapour Phase Deposition), das VAD-Verfahren (Vapour Phase Axial Deposition) oder das PECVD-Verfahren (Plasma Enhanced Chemical Vapour Deposition) genannt. Als bekanntestes Beispiel für ein Innenabscheideverfahren steht das MCVD-Verfahren (Modified Chemical Vapour Deposition), bei dem auf der Innenwandung eines von außen erhitzten Rohres SiO₂-Partikel abgeschieden werden.

Bei hinreichend hoher Temperatur im Bereich der Trägeroberfläche kommt es zu einem unmittelbaren Verglasen der SiO₂-Partikel, was auch als "Direktverglasen" bekannt ist. Im Unterschied dazu ist beim so genannten "Sootverfahren" die Temperatur beim Abscheiden der SiO₂-Partikel so niedrig, dass eine poröse SiO₂-Sootschicht erhalten wird, die dann in einem separaten Verfahrensschritt zu transparentem Quarzglas gesintert wird. Sowohl das Direktverglasen als auch das Sootverfahren führen zu einem dichten, transparenten, hochreinen, synthetischen Quarzglas.

Aus dem Stand der Technik ist als siliziumhaltiges Einsatzmaterial für die Herstellung von synthetischem Quarzglas beispielsweise Siliziumtetrachlorid (SiCl₄) bekannt. Siliziumtetrachlorid und andere analoge chlorhaltige Substanzen zeigen bei moderaten Temperaturen unter 100 °C bereits ausreichend hohe Dampfdrücke, so dass etwaige Verunreinigungen üblicherweise in der Flüssigphase verbleiben und die Herstellung von hochreinen Sootkörpern erleichtert wird.

Ein wesentlicher Nachteil derartiger chlorhaltiger Einsatzmaterialien ist jedoch, dass bei deren Umsetzung zu synthetischem Quarzglas Salzsäure entsteht, die hohe Kosten bei der Abgaswäsche und Entsorgung verursacht. In der Vergangenheit wurde daher eine Vielzahl sogenannter chlorfreier Organosiliziumverbindungen als Ausgangsmaterial für die Quarzglasherstellung erprobt. Als Beispiel seien Monosilane, Alkoxysilane, Siloxane und Silazane genannt. Eine besonders interessante Gruppe dieser sogenannten chlorfreien Organosiliziumverbindungen bilden die Polyalkylsiloxane (auch kurz als "Siloxane" bezeichnet), die beispielsweise aus der DE 30 16 010 A1 bekannt sind. Insbesondere die unter die Polyalkylsiloxane subsumierbaren Polycyclosiloxane zeichnen sich durch einen besonders hohen Anteil an Silizium pro Gewichtsanteil aus, was zur Wirtschaftlichkeit ihres Einsatzes bei der Herstellung von synthetischem Quarzglas beiträgt. Aufgrund der großtechnischen Verfügbarkeit in hoher Reinheit wird insbesondere Octamethylcyclotetrasiloxan (OMCTS) eingesetzt.

Derartige Polyalkylsiloxanverbindungen sind polymerisierbar und liegen im Einsatzmaterial in Reinform oder als Gemisch mit anderen Komponenten typischerweise in flüssiger Form vor. Sie können dem Verbraucher, wie etwa einem Abscheidebrenner, in der flüssigen Form zugeführt werden. In der Regel wird das flüssige Einsatzmaterial aber mittels eines Verdampfers in eine gasförmige oder dampfförmige Phase überführt und dem Verbraucher als kontinuierlicher Gasstrom über ein Leitungssystem zugeführt.

Basierend auf diesen sogenannten chlorfreien Ausgangsmaterialien sind in dem Stand der Technik einige Verfahren zur Herstellung von synthetischem Quarzglas beschrieben. Beispielsweise wird auf die Druckschriften EP 0 760 373 A, WO 99/15468 A, WO 99/54259 A, WO 2013/092553 A und EP 0 529 189 A verwiesen.

Obwohl die Verfahren des Standes der Technik die Verwendung von gereinigten Ausgangsmaterialien empfehlen, weisen sie teilweise den Nachteil auf, dass es während der Herstellung im Verdampfer und dem dampfführenden Leitungssystem zu einer Niederschlagsbildung oder Gelbildung kommt.

Aus der Gesamtbetrachtung des Standes der Technik ergibt sich, dass der Chlorgehalt, der Gehalt an metallischen Verunreinigungen und die Restfeuchte jeweils individuell im Ausgangsmaterial bei der Herstellung von synthetischem Quarzglas zwecks Vermeidung einer Gelbildung von Bedeutung sind. Allerdings zeigt keine der gewürdigten Dokumente, dass im Hinblick auf die Gelbildung ein funktioneller Zusammenhang zwischen den einzelnen Verunreinigungen besteht. Darüber hinaus werden die konkret für die Gelbildung verantwortlichen metallischen Verunreinigungen nicht spezifiziert.

Die Problematik der Gelbildung bei der Herstellung von synthetischem Quarzglas ausgehend von Polyalkylsiloxan tritt insbesondere bei großtechnischen Verfahren, insbesondere bei Verfahren mit einer Produktionsmenge von größer 1 t, auf und führt dazu, dass durch die Gelbildung dampfführenden Rohrleitungen, Massenflowregler, Drosseln und entsprechende Ventile mit Gelen und Rückständen belegt werden und teilweise verstopfen. Damit wird das Regel- und Durchflussverhalten des dampfführenden Gesamtsystems unkontrollierbar beeinträchtigt. Mit einer ansteigenden Gelbildung wird es daher schwieriger, den Dampffluss des Polyalkylsiloxans zu kontrollieren, was wiederum negative Auswirkungen auf die Reproduzierbarkeit des Verfahrens (z.B. Chargenvariation der Sootdichteverteilung) und der resultierenden Produkteigenschaften (z.B. Gleichförmigkeit der axialen/radialen Homogenität der Sootdichte), insbesondere bei Mehrfachbrenner-Anordnungen, hat. Darüber hinaus entstehen hohe Kosten durch die erforderliche Reinigung der verwendeten Vorrichtungen, deren gegebenenfalls notwendigen Austausch sowie durch entsprechende Stillstandzeiten während der Reinigung. Auch erhöhte Kosten aufgrund von Materialverlust sind zu berücksichtigen.

Eine zusätzliche Problematik ergibt sich bei Sootabscheideverfahren, bei denen mehrere Verbraucher gleichzeitig mit dem Einsatzmaterial gespeist werden müssen, wie etwa bei der Sootabscheidung mittels Mehrfachbrenner-Anordnung. Um eine unregelmäßige Sootabscheidung und Schichtenbildung zu vermeiden, ist es dabei besonders wichtig, dass jeder Abscheidebrenner quantitativ und qualitativ gleiche Sootaufbau-Charakteristiken hat. Schwankungen in der Gasversorgung, beispielsweise durch Ablagerungen aufgrund von Gelbildung, sind dabei möglichst zu vermeiden.

Mit den oben gewürdigten Dokumenten des Standes der Technik und den darin beschriebenen Verfahren lassen sich diese Problemstellungen nicht vollständig lösen und es besteht weiterhin Bedarf nach weiteren verbesserten Verfahren zur Herstellung von synthetischem Quarzglas.

Ausgehend von diesem Stand der Technik stellt sich die vorliegende Erfindung daher die Aufgabe, ein Verfahren zur Herstellung von synthetischem Quarzglas bereitzustellen, bei welchem die Bildung von Nebenprodukten, die insbesondere zu einer Niederschlagsbildung in den dampfführenden Vorrichtungen zur Herstellung von synthetischen Quarzglas führen, im Wesentlichen vermieden wird.

Des Weiteren stellt sich die vorliegende Erfindung die Aufgabe, ein Verfahren zur Herstellung von synthetischem Quarzglas bereitzustellen, bei welchem in einem Sootabscheideverfahren mehrere Brenner gleichzeitig mit einem Einsatzmaterial versorgt werden und eine Gleichverteilung der Massenströme über eine Vielzahl von Brenner gewährleistet ist.

Schließlich stellt sich die vorliegende Erfindung auch die Aufgabe, ein Verfahren zur Herstellung von synthetischem Quarzglas bereitzustellen, bei welchem eine Chargenvariation der Sootdichteverteilung im Wesentlichen vermieden wird und welches zu einem Soot führt, der im Wesentlichen gleichförmig ausgebildet ist und eine axiale und/oder radiale Homogenität aufweist. Insbesondere bei einem Verfahren mit Mehrfachbrenneranordnung soll die vorliegende Erfindung die Herstellung von einer in axialer und/oder radialer Richtung gleichförmig bzw. gezielt eingestellten Dichteverteilung ermöglichen. So sollen insbesondere mit der vorliegenden Erfindung in einer Mehrfachbrenneranordnung eine relative Dichtevariationen in axialer Richtung im Zwischenbereich der Endkappen von kleiner 3%, bevorzugt kleiner 2%, jeweils bezogen auf die Dichte von Quarzglas, erreicht werden.

Gelöst wird diese Aufgabe durch ein Verfahren zur Herstellung von synthetischem Quarzglas, welches die folgenden Verfahrensschritte umfasst:
(a) Verdampfen eines Einsatzmaterials, das mindestens eine polymerisierbare Polyalkysiloxanverbindung enthält, unter Bildung eines Einsatzmaterialdampfes;
(b) Zuführen des aus Verfahrensschritt (a) resultierenden Einsatzmaterialdampfes zu einer Reaktionszone, in der das Einsatzmaterial durch Pyrolyse oder durch Hydrolyse zu SiO₂-Partikeln umgesetzt wird; und
(c) Abscheiden der aus Verfahrensschritt (b) resultierenden SiO₂-Partikel auf einer Ablagerungsfläche.
(d) gegebenenfalls Trocknen und Verglasen der SiO₂-Partikel unter Bildung von synthetischem Quarzglas.

Das erfindungsgemäße Verfahren ist dann dadurch gekennzeichnet, dass während des Verfahrens
(1.) die mindestens eine Polyalkylsiloxanverbindung einen Chlorgehalt bis 550 ppb aufweist und
(2.) gleichzeitig die mindestens eine Polyalkylsiloxanverbindung einen Gehalt an metallischen Verunreinigungen an Chrom (Cr) und Zink (Zn) in Summe bis 25 ppb aufweist.

Erfindungsgemäß hat sich herausgestellt, dass es zur Vermeidung einer Gelbildung bei der Herstellung von synthetischem Quarzglas ausgehend von einer Polyalkylsiloxanverbindung auf die kombinierte, d.h. gleichzeitige, Einhaltung von Chlorgehalt und Gehalt an metallischen Verunreinigungen an Cr und Zn ankommt.

Werden daher die vorgenannten Spezifikationen an Chlor und metallischen Verunreinigungen an Cr und Zn eingehalten, kommt es zu keiner wesentlichen Gelbildung in der Vorrichtung zur Synthese von synthetischem Quarzglas und ein kontinuierlicher Betrieb bei der Herstellung lässt sich über einen langen Zeitraum, insbesondere über einen Zeitraum vor mehreren Monaten, aufrechthalten.

Das erfindungsgemäße Verfahren eignet sich zur Herstellung von synthetischem Quarzglas durch "Direktverglasen". Bei diesem Verfahren kommt es aufgrund hinreichend hoher Temperaturen bei dem Abscheiden der SiO₂-Partikel auf der Ablagerungsfläche zu einem direkten Verglasen der SiO₂-Partikel. Bei dem "Direktverglasen" wird daher auf den optionalen Verfahrensschritt (d) verzichtet. Darüber hinaus eignet sich das erfindungsgemäße Verfahren auch zur Herstellung von Quarzglas nach dem so genannten "Sootverfahren", bei welchem die Temperatur beim Abscheiden der SiO₂-Partikel im Verfahrensschritt (c) so niedrig ist, dass eine poröse SiO₂-Sootschicht erhalten wird, die in dem separaten Verfahrensschritt (d) zu synthetischem Quarzglas getrocknet und verglast wird.

Grundsätzlich kann in dem erfindungsgemäßen Verfahren jede Polyalkylsiloxanverbindung, welche sich zur Herstellung von synthetischem Quarzglas eignet, verwendet werden. Im Rahmen der Erfindung umfasst der Begriff Polyalkylsiloxan sowohl lineare (umfassend auch verzweigte Strukturen) als auch zyklische Molekularstrukturen.

Besonders geeignete zyklische Vertreter sind Polyalkylsiloxane mit der allgemeinen Summenformel

SiₚOₚ(R)₂ₚ,

wobei p eine ganze Zahl größer gleich 2 ist. Der Rest "R" ist eine Alkylgruppe, im einfachsten Fall eine Methylgruppe.

Polyalkylsiloxane zeichnen sich durch einen besonders hohen Anteil an Silizium pro Gewichtsanteil aus, was zur Wirtschaftlichkeit ihres Einsatzes bei der Herstellung von synthetischem Quarzglas beiträgt.

Die Polyalkylsiloxanverbindung ist dabei vorzugsweise ausgewählt wird aus der Gruppe, bestehend aus Hexamethylcyclotrisiloxan (D3), Octamethylcyclotetrasiloxan (D4), Dekamethylcyclopentasiloxan (D5), Dodecamethylcyclohexasiloxan (D6), Tetradekamethylcycloheptasiloxan (D7), Hexadecamethylcyclooctasiloxan (D8) sowie deren linearen Homologen. Die Notation D3, D4, D6, D7 und D8 entstammt dabei einer von General Electric Inc. eingeführten Notation, bei der "D" die Gruppe [(CH₃)₂Si]-O- repräsentiert.

Im Rahmen der vorliegenden Erfindung können auch Mischungen der vorgenannten Polyalkylsiloxanverbindungen verwendet werden.

Wegen der großtechnischen Verfügbarkeit in hoher Reinheit wird derzeit Octamethylcyclotetrasiloxan (OMCTS) bevorzugt eingesetzt. Im Rahmen der vorliegenden Erfindung ist es daher insbesondere bevorzugt, wenn es sich bei der Polyalkylsiloxanverbindung um Octamethylcyclotetrasiloxan (D4) handelt.

Im weiteren werden bevorzugte Ausführungsformen der vorliegenden Erfindung dargestellt.

### Chlorgehalt:

Im Rahmen der vorliegenden Erfindung wird unter dem Chlorgehalt die Menge an Chlor, die sich aus der Summe aller chlorhaltigen anorganischen und chlorhaltigen organischen Bestandteile ergibt, verstanden.

Wie bereits ausgeführt, weist mindestens eine Polyalkylsiloxanverbindung einen Chlorgehalt bis 550 ppb auf.

Wie bereits eingangs erläutert, enthält kommerziell verfügbares OMCTS noch Spuren an chlorhaltigen Bestandteilen. Der Grund hierfür ist, dass als Ausgangsprodukt bei der Herstellung von OMCTS in der Regel chlorhaltige Silane, wie Dimethyldichlorsilan, eingesetzt werden. Selbst nach dem Zyklisierungsprozess und nach üblicher Reinigung bzw. Destillation kann in Spuren ein Restchlorgehalt sowohl in kommerziell erhältlichem OMCTS als auch in dem im oben gewürdigten Stand der Technik verwendeten OMCTS nachgewiesen werden. Insoweit ist die im Stand der Technik genannte Produkteigenschaft "halogenfrei" bzw. "chlorfrei" so zu verstehen, dass der Gehalt an Halogen bzw. Chlor unter dem zu den jeweiligen damaligen Zeitpunkten bestehenden Messgrenzen liegt bzw. die Messungen an Halogengehalt (bzw. Chlorgehalt) im Stand der Technik höchstens im ppm-Bereich durchgeführt wurden.

Erfindungsgemäß hat sich gezeigt, dass der Druckanstieg im dampfführenden System in Abhängigkeit von der verdampften Menge für den Produktionsprozess nur dann in einer annehmbaren Größenordnung liegt, wenn unter anderem der Restchlorgehalt im entsprechenden Ausgangsmaterial einer bestimmten Spezifikation unterliegt, die der bereits zuvor genannten Bedingung entspricht.

Die im Rahmen der vorliegenden Erfindung verwendete mindestens eine Polyalkylsiloxanverbindung weist des Weiteren vorzugsweise einen Chlorgehalt bis 400 ppb, bevorzugt bis 250 ppb, weiter bevorzugt bis 180 ppb, weiter bevorzugt bis 120 ppb, auf.

Insbesondere Ausgangsmaterialien, die einen Chlorgehalt bis 180 ppb aufweisen, verhalten sich im erfindungsgemäßen Verfahren bezüglich Druckanstieg im System völlig unauffällig und ein kontinuierlicher Betrieb lässt sich über mehrere Monate aufrecht erhalten.

Für das erfindungsgemäße Verfahren ist es produktionstechnisch annehmbar, wenn die mindestens eine Polyalkylsiloxanverbindung einen Chlorgehalt von mindestens 40 ppb, insbesondere von mindestens 50 ppm, weiter insbesondere von mindestens 60 ppb, aufweist.

Daher weist die in dem erfindungsgemäßen Verfahren zu verwendende Polyalkylsiloxanverbindung einen Chlorgehalt von im Allgemeinen 40 bis 550 ppb, insbesondere von 40 bis 400 ppb, weiter insbesondere 45 bis 320 ppb, weiter insbesondere von 50 bis 250 ppb, weiter insbesondere von 20 bis 180 ppb, weiter insbesondere von 60 bis 120 ppb, auf.

Im Rahmen der vorliegenden Erfindung wird der Chlorgehalt in der Polyalkylsiloxanverbindung mit Hilfe der Neutronenaktivierungsanalyse bestimmt. Hinsichtlich den genauen Analysebedingungen wird auf die weitere Beschreibung in den Ausführungsbeispielen verwiesen.

Um den Gehalt an Chlor in der als Einsatzmaterial verwendeten Polyalkylsiloxanverbindung zu erreichen, wird die Polyalkylsiloxanverbindung vor der Verwendung in dem erfindungsgemäßen vorzugsweise einer Reinigung unterworfen. Die Reinigung kann durch übliche Vefahren zur Reinigung von Polyalkylsiloxanverbindungen erreicht werden, wobei jedoch die Reinigungsschritte solange wiederholt werden, bis die erfindungsgemäß vorgesehenen Spezifikationen der Polyalkylsiloxanverbindungen erreicht werden. Als beispielhafte, gegebenenfalls wiederholt anzuwendende Reinigungsschritte seien genannt:
- In Kontakt bringen der Polyalkylsiloxanverbindung mit absorbierenden Materialien, beispielsweise Aktivkohle und/oder Molekularsiebe, und anschließende mehrstufige Destillation;
- Extraktion von Verunreinigungen aus der Polyalkylsiloxanverbindung; und
- HPLC-Aufreinigung der Polyalkylsiloxanverbindung.

Entsprechende Verfahrensweisen zur Aufreinigung von Polyalkylsiloxanverbindungen sind beispielsweise beschrieben in GB 2459943 A, DE 103 59 951 A, EP 1 503 957 A, WO 2004/049398 A, EP 0 975 690 A, EP 0 760 373 A und EP 0 105 328.

### Gehalt an Chrom und Zink

Das Ausgangsmaterial weist darüber hinaus einen Gehalt an metallischen Verunreinigungen an Cr und Zn in Summe bis 25 ppb auf.

Erfindungsgemäß hat sich herausgestallt, dass die Gegenwart von metallischen Verunreinigungen an Cr und Zn insbesondere dann kritisch für die Gelbildung bei der Herstellung von synthetischem Quarzglas ausgehend von Polyalkylsiloxanen ist, wenn der Chlorgehalt in dem Ausgangsmaterial in den vorstehend genannten Bereichen liegt. Möglicherweise beschleunigen insbesondere die metallischen Verunreinigungen an Cr und Zn im Rückstand eine Gelbildung und unterliegen daher größeren Restriktionen im Hinblick auf ihren Gehalt in dem Ausgangsmaterial als andere metallische Verunreinigungen.

Daher ist es bevorzugt, wenn die mindestens eine Polyalkylsiloxanverbindung einen Gehalt an Cr und Zn bis 20 ppb, weiter bevorzugt bis 12 ppb, weiter bevorzugt bis 8 ppb, weiter bevorzugt bis 3 ppb, aufweist.

Für das erfindungsgemäße Verfahren ist es produktionstechnisch annehmbar, wenn die mindestens eine Polyalkylsiloxanverbindung einen Gehalt an Cr und Zn von im Allgemeinen mindestens 1 ppb, insbesondere mindestens 2 ppb, aufweist.

Daher weist die in dem erfindungsgemäßen Verfahren zu verwendende Polyalkylsiloxanverbindung einen Gehalt an Cr und Zn von im Allgemeinen 1 bis 25 ppb, insbesondere 1 bis 20 ppb, weiter insbesondere 2 bis 12 ppb, weiter insbesondere 2 bis 8 ppb, auf.

Um den Gehalt an metallischen Verunreinigungen in der als Einsatzmaterial verwendeten Polyalkylsiloxanverbindung zu erreichen, wird die Polyalkylsiloxanverbindung vor der Verwendung in dem erfindungsgemäßen Verfahren vorzugsweise einer Reinigung unterworfen. Die Reinigung erfolgt vorzugsweise wie vorstehend für die Einstellung des Chlorgehalts in der mindestens einen Polyalkylsiloxanverbindung beschrieben.

### Bevorzugte Ausführungsformen hinsichtlich Chlorgehalt und Gehalt an Cr und Zn:

Um die Gelbildung in dem erfindungsgemäßen Verfahren zu reduzieren, ist es in einer ersten Ausführungsform insbesondere bevorzugt, wenn in dem Ausgangsmaterial der Chlorgehalt bis 400 ppb und der Gehalt an metallischen Verunreinigungen an Cr und Zn bis 20 ppb beträgt.

Die Gelbildungsrate in dem erfindungsgemäßen Verfahren kann in einer zweiten Ausführungsform noch weiter reduziert werden, wenn in dem Ausgangsmaterial der Chlorgehalt bis 250 ppb und der Gehalt an Cr und Zn bis 12 ppb beträgt.

Die Gelbildungsrate in dem erfindungsgemäßen Verfahren kann in einer dritte Ausführungsform noch weiter reduziert werden, wenn in dem Ausgangsmaterial der Chlorgehalt bis 180 ppb und der Gehalt an Cr und Zn bis 8 ppb beträgt.

Die Gelbildungsrate in dem erfindungsgemäßen Verfahren kann in einer vierten Ausführungsform noch weiter reduziert werden, wenn in dem Ausgangsmaterial der Chlorgehalt bis 120 ppb und der Gehalt an Cr und Zn bis 3 ppb beträgt.

Im Rahmen der vorgenannten ersten bis vierten Ausführungsform ist es des Weiteren möglich, wenn die mindestens eine Polyalkylsiloxanverbindung einen Gehalt an Cr und Zn von mindestens 2 ppb, bevorzugt mindestens 3 ppb, weiter bevorzugt mindestens 4 ppb, weiter bevorzugt mindestens 5 ppb, aufweist.

Im Rahmen der vorgenannten ersten bis vierten Ausführungsform ist es des Weiteren möglich, wenn die mindestens eine Polyalkylsiloxanverbindung einen Chlorgehalt von mindestens 40 ppb, bevorzugt von mindestens 50 ppb, weiter bevorzugt mindestens 100 ppb, aufweist und die mindestens eine Polyalkylsiloxanverbindung einen Gehalt an Cr und Zn von mindestens 3 ppb, bevorzugt mindestens 5 ppb, aufweist.

### Restfeuchtegehalt:

Darüber hinaus hat sich erfindungsgemäß herausgestellt, dass es zu einer Vermeidung der Gelbildung bei der Synthese von synthetischem Quarzglas ausgehend von einer Polyalkylsiloxanverbindung insbesondere auch auf den Restfeuchtegehalt ankommen kann, der erfindungsgemäß vorzugsweise bis 150 ppm beträgt.

Der Restfeuchtegehalt des Ausgangsmaterials im erfindungsgemäßen Verfahren ist deutlich weniger kritisch als die vorgenannten Bedingungen zum Chlorgehalt und zum Gehalt an metallischen Verunreinigungen an Cr und Zn, kann jedoch trotzdem die Gelbildung im System beeinflussen und wird daher vorzugsweise in dem zuvor genannten Bereich eingestellt.

Der Siedepunkt von Wasser ist deutlich niedriger ist als derjenige des Polyalkylsiloxans, so dass bei einem Verdampfen des Polyalkylsiloxans es auch zu einem gleichzeitigen Verdampfen des Wassers kommt und damit zu einem Übergang des Wassers in die Dampfphase. Durch die Anwesenheit von Feuchtigkeit (Wasser) kann im Zusammenspiel mit den zuvor genannten Verunreinigungen und den hohen Verdampfungstemperaturen von mehr als 130 °C Ringöffnungsreaktionen einsetzen, die zu einer verstärkten Gelbildung bei der Verdampfung führen, insbesondere in Gegenwart von sauer oder basisch wirkenden Verunreinigungen (Lewis-Base/-Säure).

Aufgrund der Gegenwart von Restfeuchte in dem Ausgangsmaterial kann es bei der gleichzeitigen Gegenwart von chlorhaltigen Verunreinigungen, wie Chlorsilanen, zu deren Hydrolyse kommen, wodurch sich freie Salzsäure bildet. Diese freie Salzsäure wiederum kann zu einer Ringöffnung bei der Verwendung von cyclischen Polyalkylsiloxanen führen.

Insbesondere ist es bevorzugt, wenn die mindestens eine Polyalkylsiloxanverbindung einen Restfeuchtegehalt bis 130 ppm, weiter bevorzugt bis 110 ppm, weiter bevorzugt bis 90 ppm, weiter bevorzugt bis 70 ppm, weiter bevorzugt bis 50 ppm, weiter bevorzugt bis 30 ppm, aufweist.

Im Rahmen der vorliegenden Erfindung ist es akzeptabel, wenn die mindestens eine Polyalkylsiloxanverbindung einen Restfeuchtegehalt von im Allgemeinen mindestens 3 ppm, insbesondere mindestens 4 ppm, insbesondere mindestens 5 ppm, aufweist.

Üblicherweise sind Polyalkylsiloxane thermisch stabil und man kann erwarten, dass beispielsweise das cyclische OMCTS in Gegenwart von Wasserspuren bei Temperaturen zwischen 140 und 210 °C und in Abwesenheit von Katalysatoren, wie Säuren und Basen, keiner Ringöffnung unterliegt. So können beispielsweise keine Gelbildungsprodukte detektiert werden, wenn man OMCTS, welches Spuren von Wasser umfasst (z.B. 180 ppm), in einer Ampulle für 24 Stunden erwärmt. Führt man jedoch den gleichen Versuch durch und erwärmt das entsprechende Poyalkylsiloxan in der Gegenwart von Verunreinigungen (z. B. Eisenchlorid) kommt es zu einer nachweisbaren Gelbildung, die durch die Metalloberflächen oder darauf gebildeten Oxidschichten katalysiert wird.

Daher spielt die in dem Ausgangsmaterial vorhandener Restfeuchte im Hinblick auf die Gelbildung insbesondere dann eine wesentliche Rolle, wenn gleichzeitig metallische Verunreinigungen zugegen sind. Dabei erhöht sich die Gelbildungsrate mit einem ansteigenden Gehalt an Restfeuchte.

Um den Restfeuchtgehalt in der als Einsatzmaterial verwendeten Polyalkylsiloxanverbindung zu erreichen, wird die Polyalkylsiloxanverbindung vor der Verwendung in dem erfindungsgemäßen Verfahren vorzugsweise einer Reinigung unterworfen. Die Reinigung erfolgt wie vorstehend für die Einstellung des Chlorgehalts in der mindestens eine Polyalkylsiloxanverbindung beschrieben.

### Gehalt an anderen metallischen Verunreinigungen:

Ferner weist das Ausgangsmaterial vorzugsweise einen Gehalt an anderen metallischen Verunreinigungen als Cr und Zn in Summe von bis 500 ppb auf.

Bei den metallischen Verunreinigungen anders als Cr und Zn handelt sich im Allgemeinen um metallische Verunreinigungen, ausgewählt aus der Gruppe, bestehend aus Li, Na, K, Mg, Ca, Fe, Cu, Cr, Mn, Ti, Al, Ni, Mo, W, V, Co, Zn, Pb, Ba, Sr und Ag.

Die metallischen Verunreinigungen können elementar, in oxydischer als auch ionischer Form vorliegen.

Erfindungsgemäß hat sich des Weiteren herausgestellt, dass auch andere metallische Verunreinigungen außer Cr und Zn im Ausgangsmaterial die Gelbildung beeinflussen können. Während der Verdampfung des Ausgangsmaterials kommt es zu einer Aufkonzentration dieser metallischen Verunreinigungen. Ohne an eine Theorie gebunden sein zu wollen, wird davon ausgegangen, dass diese metallischen Verunreinigungen eine Gelbildung unter Polymerisation beschleunigen, was wiederum zu einem erhöhten Systemdruckanstieg führt. Daher unterliegt auch der Gehalt an metallischen Verunreinigungen außer Cr und Zn in den verwendeten Ausgangsmaterialien vorzugsweise bestimmten Beschränkungen, so dass es vorzugsweise nicht zu einer die Gelbildung fördernden Aufkonzentration kommt.

Im Rahmen der vorliegenden Erfindung ist es bevorzugt, dass die mindestens eine Polyalkylsiloxanverbindung einen Gehalt an metallischen Verunreinigungen außer Cr und Zn bis 400 ppb, bevorzugt bis 300 ppb, weiter bevorzugt bis 200 ppb, weiter bevorzugt bis 100 ppb, aufweist.

Darüber hinaus hat sich erfindungsgemäß ergeben, dass es nicht erforderlich ist, das verwendete Ausgangsmaterial vollständig frei von den genannten metallischen Verunreinigungen zu verwenden. Prozesstechnisch annehmbare Minimalmengen an metallischen Verunreinigungen außer Cr und Zn, die in der mindestens einen Polyalkylsiloxanverbindung enthalten sein können, betragen vorzugsweise mindestens 15 ppb, bevorzugt mindestens 20 ppb, weiter bevorzugt mindestens 25 ppb, weiter bevorzugt mindestens 30 ppb, weiter bevorzugt mindestens 35 ppb, weiter bevorzugt mindestens 40 ppb.

Im Rahmen der vorliegenden Erfindung wurde insbesondere festgestellt, dass metallische Verunreinigungen, die ausgewählt werden aus der Gruppe, bestehend aus Li, Na, K, Mg, Ca, Cu, Cr, Mn, Ti, Al, Ni, Mo, W, V, Co, Zn, Pb, Ba, Sr und Ag, die Gelbildung in Verfahren zur Herstellung von synthetischem Quarzglas fördern.

Um den Gehalt an metallischen Verunreinigungen in der als Einsatzmaterial verwendeten Polyalkylsiloxanverbindung zu erreichen, wird die Polyalkylsiloxanverbindung vor der Verwendung in dem erfindungsgemäßen Verfahren vorzugsweise einer Reinigung unterworfen. Die Reinigung erfolgt vorzugsweise wie vorstehend für die Einstellung des Chlorgehalts in der mindestens einen Polyalkylsiloxanverbindung beschrieben.

Durch die Einstellung des Chlorgehalts und des Gehalts an Cr und Zn in der mindestens einen Polyalkylsiloxanverbindung lassen sich in der Vorrichtung für die Herstellung von synthetischem Quarzglas stationäre Verfahrensbedingungen ohne einen Anstieg des Systemdrucks realisieren.

Darüber hinaus wird mit dem vorliegenden Verfahren erreicht, dass die Dichte des resultierenden Soots eine relative Dichtevariation in axialer Richtung im Zwischenbereich der Endkappen von kleiner 3 %, bevorzugt kleiner als 2 %, aufweist. Herstellungsbedingt haben Sootkörper eine gewisse Schichtstruktur, wobei die Schichten Bereiche lokaler Änderungen der Dichte oder der chemischen Zusammensetzung darstellen. Üblicherweise haben Sootkörper eine Dichte von 25 bis 32 %, bezogen auf die Dichte von Quarzglas. Dabei zeigen diese Sootkörper eine relative Schwankung in der Dichte, die sich beim Verglasen des Sootkörpers in den Ouarzglaskörper umsetzen und dort zu radialen, azimutalen und axialen Variationen der Hydroxylgruppen oder Chlorkonzentrationen führen, die wiederum zu ungünstigen Eigenschaften des Ouarzglaszylinders und der daraus produzierten Quarzglasfasern führen können. Mit Hilfe deserfindungsgemäßen Verfahrens lässt sich diese Dichtevariation auf die oben stehenden Grenzwerte beschränken.

Das erfindungsgemäße Verfahren eignet sich zur Herstellung von synthetischem Quarzglas, welches als ein Außen- oder Innenabscheideverfahren durchgeführt wird.

Wenn das erfindungsgemäße Verfahren zur Herstellung von synthetischem Quarzglas als ein Außenabscheideverfahren durchgeführt wird, so handelt es sich bevorzugt um ein OVD-Verfahren (outside vapour phase deposition), VAD-Verfahren (vapour phase axial deposition) oder PECVD-Verfahren (plasma enhanced chemical vapour deposition).

Wenn das erfindungsgemäße Verfahren zur Herstellung von synthetischem Quarzglas als ein Innenabscheideverfahren durchgeführt wird, so handelt es sich bevorzugt um ein MCVD-Verfahren (modified chemical vapour deposition).

Des Weiteren betrifft die vorliegende Erfindung die Verwendung einer Polyalkylsiloxanverbindung zur Herstellung von synthetischem Quarzglas, die einen Chlorgehalt bis 500 ppb und einen Gehalt an metallischen Verunreinigungen an Cr und Zn bis 25 ppb aufweist.

Des Weiteren ist die Verwendung von Polyalkylsiloxanverbindungen von der vorliegenden Erfindung umfasst mit einem Chlorgehalt bis 400 ppb und einem Gehalt an metallischen Verunreinigungen an Cr und Zn bis 16 ppb.

Des Weiteren ist die Verwendung von Polyalkylsiloxanverbindungen von der vorliegenden Erfindung umfasst mit einem Chlorgehalt bis 250 ppb und einem Gehalt an metallischen Verunreinigungen an Cr und Zn bis 8 ppb.

Des Weiteren ist die Verwendung von Polyalkylsiloxanverbindungen von der vorliegenden Erfindung umfasst mit einem Chlorgehalt bis 180 ppb und einem Gehalt an metallischen Verunreinigungen an Cr und Zn bis 3 ppb.

Die Verwendung der vorstehend beschriebenen Polyalkylsiloxanverbindungen mit den genannten Spezifikation erfolgt in einem wie oben beschriebenen Verfahren zur Herstellung von einem synthetischem Quarzglas.

Die vorliegende Erfindung wird anhand der nachfolgenden Beispiele näher erläutert.

### 1. Versuchsdurchführung zur Herstellung von synthetischem Quarzglas

Mit einem Verdampfer gemäß DE 10 2013 209 673 wurde OMCTS verdampft und der Systemdruckanstieg im dampfführenden Leitungssystem wurde gemessen. Der gemessene Systemdruckanstieg ergibt sich aus der Änderung des Druckes im Verdampfer und dampfführenden Leitungssystem mit zunehmender Verdampfungsmenge. Es ist ein direktes Maß für die Abscheidung von Polymerisaten im Verdampfersystem. Die Temperatur im dampfführenden System wird während des Versuchs konstant auf 180 °C gehalten. Idealerweise sollte die Temperatur zw. 160 - 190 °C liegen. Wichtig ist, dass es im dampfführenden System nicht lokal zu einer Taupunktsunterschreitung kommt. Das Ausgangsmaterial wird zusammen mit einem inerten Trägergas in die Verdampfungskammer eingespritzt. Als Trägergas wird Stickstoff verwendet.

### 2. Bestimmung der Restfeuchte

Die Bestimmung der Restfeuchte in der Polyalkylsiloxanverbindung erfolgte über die Karl-Fischer-Titration, wobei eine volumetrische oder coulometrische Verfahrensweise verwendet werden kann. Das Verfahren wird mit der Apparatur TitroLine kF bzw. TitroLine kF *trace* der Firma SI Analytics gemäß Standardanweisung durchgeführt.

### 3. Bestimmung der Metallgehalte

Die Bestimmung der metallischen Verunreinigungen in der Polyalkylsiloxanverbindung erfolgte mittels ICP-HS-Analyse. Dabei erfolgte ein Druckaufschluss des Polyalkylsiloxans in Flusssäure (HF), ein Abrauchen der Flusssäure (HF) und von H₂SiF₆, ein Auffüllen mit destilliertem Wasser und die Vermessung der wässrigen Lösung mittels ICP-MS (Gerät: Agilent 7500ce)

Die Kalibrierung erfolgte mit Standards, ebenfalls in wässriger Lösung.

### 4. Bestimmung des Chlorgehalts

Die Bestimmung des Chlorgehalts erfolgte mittels Neutronenaktivierungsanalyse am Helmholz-Zentrum Berlin.

### 5. Ergebnisse

In Abhängigkeit vom Chlorgehalt und dem Gehalt an Zink und Chrom in dem Ausgangsmaterial wurden folgende Ergebnisse erhalten:
++: kein Systemdruckanstieg (innerhalb > 7d);
+: sehr geringer Systemdruckanstieg, welcher ohne Auswirkung auf das Verfahren zur Herstellungen synthetischem Quarzglas ist (innerhalb 7d);
o: geringer Systemdruckanstieg, welcher verfahrenstechnisch noch akzeptabel ist (innerhalb 2d);
-: hoher Systemdruckanstieg, welcher verfahrenstechnisch nicht mehr akzeptabel ist (innerhalb 1d);
--: sehr hoher Systemdruckanstieg, welcher verfahrenstechnisch nicht akzeptabel ist (innerhalb 6 Stunden).

| **Beispiel** | **Chlorgehalt [ppb]** | **σ Chlor [ppb]** | **Sum Zn + Cr [ppb]** | **Perfomance bzgl. Systemdruckanstieg pro Mengeneinheit** |
|---|---|---|---|---|
| Exp. 1 | 50 | 10 | <3 | +++ |
| Exp. 2 | 50 | 10 | 21 | ++ |
| Exp. 3 | 50 | 10 | 25 | + |
| Exp. 4 | 180 | 30 | <3 | ++ |
| Exp. 5 | 180 | 30 | 16 | ++ |
| Exp. 6 | 180 | 30 | 24 | ○ |
| Exp. 7 | 180 | 30 | 32 | ○ |
| Exp. 8 | 180 | 30 | 45 | - |
| Exp. 9 | 410 | 55 | <3 | ++ |
| Exp. 10 | 410 | 55 | 34 | + |
| Exp. 11 | 520 | 70 | 3 | + |
| Exp. 12 | 520 | 70 | 26 | - |
| Exp. 13 | 850 | 100 | <3 | - |
| Exp. 14 | 850 | 100 | 30 | -- |

| | | | | |
|---|---|---|---|---|
| σ Chlor: Standardabweichung | | | | |

Die Beispiele 7, 8, 10 sowie 12 bis 14 sind aufgrund des Gehalts an metallischen Verunreinigungen an Chrom (Cr) und Zink (Zn) Vergleichsbeispiele.

Die Beispiele zeigen, dass gleichzeitig eine Einhaltung eines oberen Grenzwertes an Chlor in der Ausgangsverbindung von 550 ppb und eines oberen Grenzwertes von Chrom und Zink von 25 ppb erforderlich ist, um eine Gelbildung in der Vorrichtung zur Herstellung von synthetischem Quarzglas zu vermeiden (Vergleich des Beispiels 11 mit den Beispielen 8 und 13). In den Beispielen 8 und 13 liegen jeweils entweder der Chlorgehalt oder der Gehalt an Chrom und Zink außerhalb des erfindungsgemäßen Bereiches, während im Beispiel 11 sowohl der Chlorgehalt als auch der Gehalt an Chrom und Zink in den erfindungsgemäßen Bereichen liegen.

Das Beispiel 8 verdeutlicht, dass trotz einem erfindungsgemäßen Chlorgehalt in der verwendeten Ausgangsverbindung eine Gelbildung in der Vorrichtung nicht verhindert werden kann, wenn der Gehalt an Verunreinigungen an Chrom und Zink oberhalb des erfindungsgemäßen Grenzwertes liegt, während das Beispiel 13 zeigt, dass eine Gelbildung in der Vorrichtung nicht verhindert werden kann, wenn der Gehalt an Chlorverunreinigung in dem Ausgangsmaterial höher ist als der Grenzwert, obwohl der erfindungsgemäße Gehalt an Verunreinigungen an Chrom und Zink eingehalten wird.

## Patentansprüche

1. Verfahren zur Herstellung von synthetischem Quarzglas, umfassend die folgenden Verfahrensschritte:
(a) Verdampfen eines Einsatzmaterials, das mindestens eine polymerisierbare Polyalkysiloxanverbindung enthält, unter Bildung eines Einsatzmaterialdampfes;
(b) Zuführen des aus Verfahrensschritt (a) resultierenden Einsatzmaterialdampfes zu einer Reaktionszone, in der das Einsatzmaterial durch Pyrolyse oder durch Hydrolyse zu SiO₂-Partikeln umgesetzt wird; und
(c) Abscheiden der aus Verfahrensschritt (b) resultierenden SiO₂- Partikel auf einer Ablagerungsfläche,
(d) gegebenenfalls Trocknen und Verglasen der aus Verfahrensschritt (c) resultierenden SiO₂-Partikel unter Bildung von synthetischem Quarzglas,
**dadurch gekennzeichnet, dass** die mindestens eine Polyalkylsiloxanverbindung einen Chlorgehalt bis 550 ppb und einen Gehalt an metallischen Verunreinigungen an Chrom (Cr) und Zink (Zn) in Summe bis 25 ppb aufweist.

2. Verfahren nach einem der vorherigen Ansprüche, **dadurch gekennzeichnet, dass** die mindestens eine Polyalkylsiloxanverbindung einen Chlorgehalt bis 400 ppb aufweist.

3. Verfahren nach einem der vorherigen Ansprüche, **dadurch gekennzeichnet, dass** die mindestens eine Polyalkylsiloxanverbindung einen Chlorgehalt von mindestens 40 ppb aufweist.

4. Verfahren nach einem der vorherigen Ansprüche, **dadurch gekennzeichnet, dass** die mindestens eine Polyalkylsiloxanverbindung einen Gehalt an metallischen Verunreinigungen an Cr und Zn bis 16 ppb aufweist.

5. Verfahren nach einem der vorherigen Ansprüche, **dadurch gekennzeichnet, dass** die mindestens eine Polyalkylsiloxanverbindung einen Gehalt an metallischen Verunreinigungen an Cr und Zn von mindestens 2 ppb aufweist.

6. Verfahren nach einem der vorherigen Ansprüche, **dadurch gekennzeichnet, dass** die mindestens eine Polyalkylsiloxanverbindung einen Restfeuchtegehalt bis 150 ppm aufweist.

7. Verfahren nach einem der vorherigen Ansprüche, **dadurch gekennzeichnet, dass** die mindestens eine Polyalkylsiloxanverbindung einen Restfeuchtegehalt von mindestens 3 ppm aufweist.

8. Verfahren nach einem der vorherigen Ansprüche, **dadurch gekennzeichnet, dass** die mindestens eine Polyalkylsiloxanverbindung vor ihrer Verwendung als Einsatzmaterial einer Reinigung unterworfen wird, um den Chlorgehalt und den Gehalt an metallischen Verunreinigungen an Cr und Zn auf die zuvor genannten Bereich einzustellen.

9. Verfahren nach einem der vorherigen Ansprüche, **dadurch gekennzeichnet, dass** in den Verfahrensschritten (a) bis (c) eine Multibrenner-Anordnung mit 2 oder mehr Brennern zum Einsatz kommt.

10. Verwendung einer Polyalkylsiloxanverbindung, welche einen Chlorgehalt bis 550 ppb und einen Gehalt an metallischen Verunreinigungen an Chrom (Cr) und Zink (Zn) in Summe bis 25 ppb aufweist, zur Herstellung von synthetischem Quarzglas durch folgende Verfahrensschritte:
a) Verdampfen eines Einsatzmaterials, das mindestens die polymerisierbare Polyalkysiloxanverbindung enthält, unter Bildung eines Einsatzmaterialdampfes;
(b) Zuführen des aus Verfahrensschritt (a) resultierenden Einsatzmaterialdampfes zu einer Reaktionszone, in der das Einsatzmaterial durch Pyrolyse oder durch Hydrolyse zu SiO₂-Partikeln umgesetzt wird; und
(c) Abscheiden der aus Verfahrensschritt (b) resultierenden SiO₂- Partikel auf einer Ablagerungsfläche,
(d) gegebenenfalls Trocknen und Verglasen der aus Verfahrensschritt (c) resultierenden SiO₂-Partikel unter Bildung von synthetischem Quarzglas.

## Claims

1. A method for manufacturing synthetic quartz glass, comprising the following process steps:
(a) vaporizing an input material which contains at least one polymerizable polyalkylsiloxane compound while forming an input material vapour;
(b) supplying the input material vapour resulting from process step (a) to a reaction zone, in which the input material is transformed into SiO₂ particles by means of pyrolysis or hydrolysis; and
(c) precipitating the SiO₂ particles resulting from process step (b) on a deposition surface,
(d) if required, drying and glazing the SiO₂ particles resulting from process step (c) while forming synthetic quartz glass,
**characterized in that** the at least one polyalkylsiloxane compound comprises a chlorine content of up to 550 ppb and a concentration of metallic impurities of chrome (Cr) and zinc (Zn) in total of up to 25 ppb.

2. A method according to one of the preceding claims, **characterized in that** the at least one polyalkylsiloxane compound comprises a chlorine content of up to 400 ppb.

3. A method according to one of the preceding claims, **characterized in that** the at least one polyalkylsiloxane compound comprises a chlorine content of at least 40 ppb.

4. A method according to one of the preceding claims, **characterized in that** the at least one polyalkylsiloxane compound comprises a concentration of metallic impurities of Cr and Zn of up to 16 ppb.

5. A method according to one of the preceding claims, **characterized in that** the at least one polyalkylsiloxane compound comprises a concentration of metallic impurities of Cr and Zn of at least 2 ppb.

6. A method according to one of the preceding claims, **characterized in that** the at least one polyalkylsiloxane compound comprises a residual moisture content of up to 150 ppm.

7. A method according to one of the preceding claims, **characterized in that** the at least one polyalkylsiloxane compound comprises a residual moisture content of at least 3 ppm.

8. A method according to one of the preceding claims, **characterized in that** the at least one polyalkylsiloxane compound will be submitted to a cleaning before being used as input material, in order to set the chlorine content and the concentration of metallic impurities of Cr and Zn within the above mentioned ranges.

9. A method according to one of the preceding claims, **characterized in that** a multi-burner arrangement having two or more burners will be used in the process steps (a) through (c).

10. A use of a polyalkylsiloxane compound which comprises a chlorine content of up to 550 ppb and a concentration of metallic impurities of chrome (Cr) and zinc (Zn) in total of up to 25 ppb, for producing synthetic quartz glass by means of the following process steps:
(a) vaporizing an input material which contains at least the polymerizable polyalkylsiloxane compound while forming an input material vapour;
(b) supplying the input material vapour resulting from process step (a) to a reaction zone, in which the input material is transformed into SiO₂ particles by means of pyrolysis or hydrolysis; and
(c) precipitating the SiO₂ particles resulting from process step (b) on a deposition surface,
(d) if required, drying and glazing the SiO₂ particles resulting from process step (c) while forming synthetic quartz glass.

## Revendications

1. Procédé de fabrication de verre de quartz synthétique, comprenant les étapes de procédé suivantes de:
(a) vaporiser un matériau utilisé, qui contient au moins un composé de polyalkylesiloxane polymérisable, avec formation d'une vapeur de matériau utilisé ;
(b) amener la vapeur de matériau utilisé résultant de l'étape de procédé (a) à une zone de réaction, dans laquelle le matériau utilisé est transformé en des particules de SiO₂ par la pyrolyse ou par l'hydrolyse ; et
(c) précipiter les particules de SiO₂ résultant de l'étape de procédé (b) sur une surface de dépôt,
(d) le cas échéant, sécher et vitrer les particules de SiO₂ résultant de l'étape de procédé (c) avec formation de verre de quartz synthétique,
**caractérisé en ce que** l'au moins un composé de polyalkylesiloxane comprend une teneur en chlore de jusqu'à 550 ppb et une teneur en impuretés métalliques de chrome (Cr) et de zinc (Zn) en somme de jusqu'à 25 ppb.

2. Procédé selon l'une des revendications précédentes, **caractérisé en ce que** l'au moins un composé de polyalkylesiloxane comprend une teneur en chlore de jusqu'à 400 ppb.

3. Procédé selon l'une des revendications précédentes, **caractérisé en ce que** l'au moins un composé de polyalkylesiloxane comprend une teneur en chlore d'au moins 40 ppb.

4. Procédé selon l'une des revendications précédentes, **caractérisé en ce que** l'au moins un composé de polyalkylesiloxane comprend une teneur en impuretés métalliques de Cr et de Zn de jusqu'à 16 ppb.

5. Procédé selon l'une des revendications précédentes, **caractérisé en ce que** l'au moins un composé de polyalkylesiloxane comprend une teneur en impuretés métalliques de Cr et de Zn d'au moins 2 ppb.

6. Procédé selon l'une des revendications précédentes, **caractérisé en ce que** l'au moins un composé de polyalkylesiloxane comprend une teneur en humidité résiduelle de jusqu'à 150 ppm.

7. Procédé selon l'une des revendications précédentes, **caractérisé en ce que** l'au moins un composé de polyalkylesiloxane comprend une teneur en humidité résiduelle d'au moins 3 ppm.

8. Procédé selon l'une des revendications précédentes, **caractérisé en ce que** l'au moins un composé de polyalkylesiloxane est soumis à un nettoyage avant d'être utilisé comme matériau utilisé pour ajuster la teneur en chlore et la teneur en impuretés métalliques de Cr et de Zn dans les gammes mentionnées ci-dessus.

9. Procédé selon l'une des revendications précédentes, **caractérisé en ce qu'**on utilise un ensemble à multi-brûleurs ayant deux ou plus de brûleurs dans les étapes de procédé (a) à (c).

10. Utilisation d'un composé de polyalkylesiloxane, qui comprend une teneur en chlore de jusqu'à 550 ppb et une teneur en impuretés métalliques de chrome (Cr) et de zinc (Zn) en somme de jusqu'à 25 ppb, pour la fabrication de verre de quartz synthétique à l'aide des étapes de procédé de :
(a) vaporiser un matériau utilisé, qui contient au moins le composé de polyalkylesiloxane polymérisable, avec formation d'une vapeur de matériau utilisé ;
(b) amener la vapeur de matériau utilisé résultant de l'étape de procédé (a) à une zone de réaction, dans laquelle le matériau utilisé est transformé en des particules de SiO₂ par la pyrolyse ou par l'hydrolyse ; et
(c) précipiter les particules de SiO₂ résultant de l'étape de procédé (b) sur une surface de dépôt,
(d) le cas échéant, sécher et vitrer les particules de SiO₂ résultant de l'étape de procédé (c) avec formation de verre de quartz synthétique.
